# EUROPÄISCHE PATENTSCHRIFT

(11) **EP 0 504 712 B1**
(45) Veröffentlichungstag und Bekanntmachung des Hinweises auf die Patenterteilung: **26.07.1995**
(21) Anmeldenummer: 92104092.9
(22) Anmeldetag: 10.03.1992
(51) Int. Cl.: C30B 25/02

(54) **Verfahren zur Herstellung einer monokristallinen Siliciumcarbid-Schicht**
Process for producing single crystal silicon carbide layer
Procédé de préparation de couche monocristalline de carbure de silicium

(30) Priorität: 19.03.1991 DE 4109005
(43) Veröffentlichungstag der Anmeldung: 23.09.1992
(73) Patentinhaber: CS HALBLEITER-UND SOLARTECHNOLOGIE GMBH, D-80339 München (DE)
(72) Erfinder: Scholz, Christoph, Dr., W-8162 Schliersee (DE); Just, Wolfgang, W-8000 München 80 (DE)
(74) Vertreter: Haft, von Puttkamer, Berngruber, Czybulka

(56) Entgegenhaltungen:
- DE-A- 3 415 799
- DE-A- 3 446 956
- DE-A- 3 613 012
- PATENT ABSTRACTS OF JAPAN vol. 4, no. 159 (C-80)(641) 6. November 1980
- PATENT ABSTRACTS OF JAPAN vol. 5, no. 16 (C-41)(688) 30. Januar 1981
- PATENT ABSTRACTS OF JAPAN vol. 5, no. 106 (C-62)(778) 10. Juli 1981

## Beschreibung

Die Erfindung bezieht sich auf ein Verfahren zur Herstellung einer monokristallinen Siliciumcarbid-Schicht durch Epitaxie-Aufwachsen auf nur einer Seite einer monokristallinen Silicium-Schicht.

Monokristallines Siliciumcarbid (SiC) stellt aufgrund seiner Hochtemperatureigenschaften einen an sich sehr wünschenswerten Verbindungshalbleiter dar.

Bisher sind im wesentlichen zwei Verfahren bekannt, um monokristalline SiC-Wafer herzustellen (vgl. Springer Proceedings in Physics, Vol. 43, "Amorphous and Crystalline Silicon Carbide and Related Materials II", Springer-Verlag Berlin, Heidelberg 1989). Bei dem einen Verfahren wird ein SiC-Kristall hergestellt, indem man SiC sublimiert und auf einen SiC-Impfkristall aufwachsen läßt. Das bekannte Verfahren ist extrem aufwendig. Auch läßt der Reinheitsgrad des erhaltenen monokristallinen SiC zu wünschen übrig. Dies ist darauf zurückzuführen, daß bei der erwähnten hohen Temperatur das SiC in der hexagonalen Form gebildet wird, die jedoch polytypisch ist. Die bei tieferen Temperaturen als Monotyp auftretende kubische und von den elektronischen Eigenschaften her vorzuziehende Form ist nach diesem Verfahren hingegen nicht erhältlich. Ferner ist dieses Verfahren auf die Herstellung kleiner Wafer von wenigen Zentimetern Durchmesser beschränkt.

Das andere Verfahren zur Herstellung von monokristallinem Siliciumcarbid erfolgt mittels Epitaxie, also einem thermischen CVD-Verfahren. Dabei wird einem erhitzten Substrat ein Silan und ein Kohlenwasserstoff, wie Propan, zugeführt, wodurch sich SiC-Schichten ausbilden.

Das Problem des Epitaxie-Aufwachsens von SiC besteht jedoch darin, daß man als Substrat eine monokristalline Siliciumcarbid-Schicht braucht, auf der man das Aufwachsen durchführen kann. Im Handel sind Siliciumcarbid-Einkristalle nicht erhältlich. Werden sie nach dem zuerst genannten aufwendigen Verfahren hergestellt, sind sie zu klein, um Siliciumcarbid-Wafer mit genügend großem Durchmesser durch Epitaxie-Aufwachsen herstellen zu können, und im übrigen mit den genannten Fehler behaftet.

Man ist deshalb auf eine monokristalline Silicium(Si)-Scheibe (Wafer) als Heterosubstrat ausgewichen, da monokristallines Si eine monokristallinem SiC ähnliche Kristallstruktur besitzt und als Wafer im Handel mit einem Durchmesser von bis zu 200 mm und mehr erhältlich ist.

Bei diesem (Hetero-)Epitaxie-Verfahren erhält man also einen Verbund aus dem Si-Substrat und der darauf aufgewachsenen SiC-Schicht. Si und SiC besitzen jedoch voneinander stark abweichende Wärmeausdehnungskoeffizienten, und zwar zieht sich SiC beim Abkühlen stärker zusammen als Si. Dies hat zur Folge, daß die durch Heteroepitaxie hergestellten SiC-Schichten beim Abkühlen einer Zugspannung ausgesetzt sind, die eine hohe Versetzungsdichte in der SiC-Schicht induziert. Ganz abgesehen davon kann die Si-Schicht reißen, insbesondere wenn der als Substrat verwendete Si-Wafer zu dünn ist, oder es können Mikrorisse in der SiC-Schicht auftreten, wenn beispielsweise ein zu dicker Si-Wafer als Substrat eingesetzt wird.

Aus der DE 36 13 012 A1 und DE 34 46 956 A1 ist die Herstellung einer monokristallinen Si-Schicht durch Aufwachsen von alpha-SiC auf eine monokristalline beta-SiC-Schicht bekannt. Die beta-SiC-Schicht wird hergestellt, indem ein dünner SiC-Film nach dem CVD-Verfahren auf eine monokristalline Si-Schicht aufwachsen gelassen wird, woran sich die Entfernung der Si-Schicht mittels einer Säure anschließt

Nach DE-A-3 415 799 wird eine monokristalline Siliciumcarbid-Schicht hergestellt, indem auf das Siliciumsubstrat eine dünne amorphe Siliciumcarbid-Trennschicht aufgebracht wird, auf der dann die monokristalline Siliciumcarbid-Schicht abgeschieden wird. Nach JP-A-55-105000 wird auf ein Siliciumsubstrat in der Gasphase erst eine polykristalline Siliciumcarbid-Schicht aufgebracht, dann das Siliciumsubstrat geschmolzen, um durch Flüssigphasen-Epitaxie eine monokristalline Siliciumcarbid-Schicht auf der Seite der polykristallinen Siliciumcarbid-Schicht aufzubringen, die dem Siliciumsubstrat zugewandt war. Das geschmolzene Silicium wird anschließend durch Ätzen entfernt.

Aufgabe der Erfindung ist es, eine monokristalline SiC-Schicht mit einem normalen Wafer-Durchmesser bereitzustellen, welche höchsten Anforderungen der Halbleiter-Technik genügt.

Dies wird erfindungsgemäß nach dem im Anspruch 1 gekennzeichneten Verfahren erreicht.

Bei dem erfindungsgemäßen Verfahren kann das Epitaxie-Aufwachsen des SiC auf dem Si-Substrat in üblicher Art und Weise erfolgen. D. h., das Si-Substrat wird z. B. in einer evakuierten oder z.B. mit Edelgasen und/oder Wasserstoff gespülten Kammer auf eine Temperatur von vorzugsweise 800 bis 1400°C erwärmt, worauf der Kammer ein Silan und ein Kohlenwasserstoff, wie Propan, oder eine gasförmige Silicium-Kohlenstoff-Verbindung zugeführt werden, um eine SiC-Schicht zu bilden.

Erfindungsgemäß wird jedoch im Gegensatz zum Stand der Technik der Verbund aus der aufgewachsenen SiC-Schicht und dem Si-Substrat von der Temperatur, bei der die Epitaxie durchgeführt wird, also von vorzugsweise 800 bis 1400°C, nicht abgekühlt, vielmehr wird dieser Verbund weiter aufgeheizt, und zwar vorzugsweise bis knapp unter oder bis über den Schmelzpunkt von Silicium von 1432°C, wodurch die Silicium-Schicht von dem Verbund abgeschmolzen bzw. durch Sublimation verdampft wird, so daß die monokristalline SiC-Schicht zurückbleibt. Ferner ist es möglich, ohne den Verbund abzukühlen, das Silicium abzuätzen, z. B. mit einem Ätzgas oder durch Plasma-Ätzen.

Damit die Si-Schicht von dem Verbund entfernt werden kann, ist es bei dem erfindungsgemäßen Verfahren erforderlich, daß das SiC nur auf einer Seite des Si-Substrats aufwächst. Dies kann dadurch erreicht werden, daß das Si-Substrat beim Epitaxie-Aufwachsen des SiC auf einer Platte liegt, so daß sich auf der der Platte zugewandten Seite des Si-Substrats kein SiC abscheiden kann. Auch ist es möglich, eine Seite des Si-Substrats mit einem Inertgas zu spülen oder Vakuum auszusetzen, um eine SiC-Abscheidung an dieser Seite des Si-Substrats zu verhindern.

In der ersten Phase des Epitaxie-Aufwachsens ist eine langsame SiC-Abscheidungsgeschwindigkeit erforderlich, damit sich eine störungsfreie monokristalline SiC-Schicht ausbilden kann. Demgemäß wird in der ersten Phase des Epitaxie-Aufwachsens nach dem erfindungsgemäßen Verfahren eine Abscheidungsgeschwindigkeit des SiC von weniger als 20 »m/h bevorzugt, vorzugsweise von 5 bis 10 »m/h, bis eine SiC-Schichtdicke von 5 bis 50 »m erreicht ist. In der zweiten Phase wird dann die SiC-Abscheidungsgeschwindigkeit erhöht. Es ist dann sogar möglich, statt dem thermischen CVD-Verfahren ein Plasma-CVD-Verfahren durchzuführen, also eine chemische Abscheidung aus einer Dampfphase, die zumindest teilweise als Plasma vorliegt. Dadurch kann in der zweiten Phase die Abscheidungsgeschwindigkeit auf 100 »m/h oder gar 300 »m/h erhöht werden.

In der Zeichnung ist das erfindungsgemäße Verfahren anhand eines Fließschemas näher erläutert.

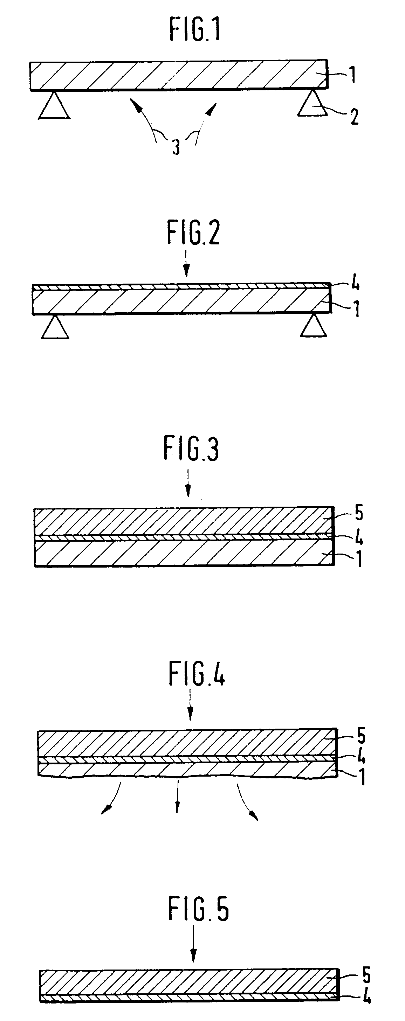

Danach wird gemäß Fig. 1 monokristallines Silicium-Substrat 1, das auf einem Substrathalter 2 angeordnet ist, in einer nicht dargestellten Kammer erhitzt, wobei die eine Seite des Substrats 1 mit einem Inertgas gespült wird, wie durch die Pfeile 3 verdeutlicht.

Gemäß Fig. 2 läßt man dann durch Epitaxie auf das Si-Substrat 1 eine Siliciumcarbid-Epitaxieschicht 4 aufwachsen, und zwar bis zu einer Schichtdicke von beispielsweise 30 »m. Wenn die dünne SiC-Epitaxieschicht 4 gebildet worden ist, erfolgt gemäß Fig. 3 ein schnelleres Aufwachsen einer dickeren SiC-Trägerschicht 5, beispielsweise durch Plasmaunterstützung_{,} wobei das Wachstum der SiC-Schicht polykristallin ist. Für die Verwendung des erfindungsgemäß hergestellten SiC-Wafers als Halbleitermaterial ist es nämlich ausreichend, daß auf einer Seite eine monokristalline SiC-Struktur von z. B. bis zu 50 »m vorliegt. Demgegenüber dient die zweite SiC-Schicht nur als Träger, also zur mechanischen Verstärkung des Wafers. Gemäß Fig. 4 wird anschließend das Si-Substrat 1 z. B. durch Verdampfen entfernt, so daß eine monokristalline SiC-Halbleiterschicht 4 auf der polykristallinen SiC-Trägerschicht 6 zurückbleibt (Fig. 5).

## Patentansprüche

1. Verfahren zur Herstellung eines Verbundes aus einer monokristallinen Siliciumcarbid-Schicht und einer polykristallinen Siliciumcarbid-Schicht durch Aufwachsen einer ersten Siliciumcarbid-Schicht in der Gasphase auf einer Seite eines monokristallinen Silicium-Substrats, Aufwachsen einer zweiten Siliciumcarbid-Schicht und Entfernen des Silicium-Substrats ohne vorherige Abkühlung, dadurch gekennzeichnet, daß man die monokristalline Siliciumcarbid-Schicht als erste Schicht durch Gasphasen-Epitaxie und auf der von dem Silicium-Substrat abgewandten Seite der monokristallinen Siliciumcarbid-Schicht durch Erhöhung der Abscheidungsgeschwindigkeit aus der Gasphase die polykristalline Siliciumcarbid-Schicht als zweite Schicht aufwachsen läßt, um einen Verbund aus dem festen Silicium-Substrat, der monokristallinen Siliciumcarbid-Schicht und der polykristallinen Siliciumcarbid-Schicht zu bilden, von dem das Silicium-Substrat entfernt wird.

2. Verfahren nach Anspruch 1, dadurch gekennzeichnet, daß das Entfernen des Silicium-Substrats durch Abschmelzen, Verdampfen oder Ätzen erfolgt.

3. Verfahren nach Anspruch 1 oder 2, dadurch gekennzeichnet, daß zum Aufwachsen des Siliciumcarbids auf nur einer Seite des Silicium-Substrats die gegenüberliegende Seite des Silicium-Substrats auf eine Platte gelegt oder mit einem Inertgas oder Vakuum beaufschlagt wird.

4. Verfahren nach Anspruch 3, dadurch gekennzeichnet, daß als Inertgas Edelgas und/oder Wasserstoff verwendet wird.

5. Verfahren nach einem der vorstehenden Ansprüche, dadurch gekennzeichnet, daß das Gasphasen-Epitaxie-Aufwachsen des monokristallinen Siliciumcarbids auf das Silicium-Substrat in einer ersten Phase mit einer Abscheidungsgeschwindigkeit von weniger als 20 »m/h durchgeführt wird, bis eine monokristalline Siliciumcarbid-Schichtdicke von 5 bis 50 »m erreicht ist, worauf die Abscheidungsgeschwindigkeit in einer zweiten Phase erhöht wird, um die polykristalline Siliciumcarbid-Schicht zu bilden.

6. Verfahren nach Anspruch 5, dadurch gekennzeichnet, daß die Abscheidungsgeschwindigkeit des monokristallinen Siliciumcarbids in der ersten Phase 5 bis 10 »m/h beträgt.

7. Verfahren nach Anspruch 5 oder 6, dadurch gekennzeichnet, daß das Aufwachsen des polykristallinen Siliciumcarbids in der zweiten Phase durch Plasma-CVD erfolgt.

## Claims

1. A method for producing a compound of a monocrystalline silicon carbide layer and a polycrystalline silicon carbide layer by growing a first silicon carbide layer on one side of a monocrystalline silicon substrate in a gaseous phase, growing a second silicon carbide layer and removing the silicion substrate without previous cooling, characterized in that the monocrystalline silicon carbide layer is grown as first layer by gaseous epitaxial growth, and as second layer the polycrystalline silicon carbide layer is grown from the gaseous phase on the side of the monocrystalline silicon carbide layer opposite the silicon substrate by increasing the deposition rate, to form a compound of the solid silicon substrate, the monocrystalline silicon carbide layer and the polycrystalline silicon carbide layer, from which the silicon substrate is removed.

2. The method of claim 1, characterized in that the silicon substrate is removed by melting off, vaporization or etching.

3. The method of claim 1 or 2, characterized in that the opposite side of the silicon substrate is placed on a plate or subjected to an inert gas or vacuum in order for the growth of the silicon carbide to take place on only one side of the silicon substrate.

4. The method of claim 3, characterized in that noble gas and/or hydrogen is used as an inert gas.

5. The method of one of the above claims, characterized in that the epitaxial growth of the silicon carbide on the silicon substrate in the gaseous phase is performed in a first phase with a deposition rate of less than 20 »m/h until a silicon carbide layer thickness of 5 to 50 »m is reached, whereupon the deposition rate is increased in a second phase to form the polycrystalline silicon carbide layer.

6. The method of claim 5, characterized in that the deposition rate of the monocrystalline silicon carbide in the first phase is 5 to 10 »m/h.

7. The method of claim 5 or 6, characterized in that the growth of the polycrystalline silicon carbide in the second phase takes place by plasma CVD.

## Revendications

1. Procédé de préparation d'une structure composite constituée par une couche monocristalline de carbure de silicium et une couche polycristalline de carbure de silicium en faisant croître une première couche de carbure de silicium dans la phase gazeuse sur une face d'un substrat monocristallin de silicium, en faisant croître une seconde couche de carbure de silicium et en enlevant le substrat de silicium sans refroidissement préliminaire, caractérisé en ce que l'on fait croître la couche monocristalline de carbure de silicium formant la première couche par épitaxie en phase gazeuse et que l'on fait croître sur la couche monocristalline de carbure de silicium, sur la face détournée du substrat de silicium, la couche polycristalline de carbure de silicium formant la seconde couche, en augmentant la vitesse de séparation issue de la phase gazeuse, pour former une structure composite constituée par le substrat de silicium solide, la couche de carbure de silicium monocristallin et la couche polycristalline de carbure de silicium, structure composite de laquelle on enlève le substrat de silicium.

2. Procédé selon la revendication 1, caractérisé en ce que l'enlèvement du substrat de silicium est effectué par séparation par fusion, évaporation ou corrosion.

3. Procédé selon l'une ou l'autre des revendications 1 et 2, caractérisé en ce que pour faire croître le carbure de silicium sur seulement une face du substrat de silicium, la face opposée du substrat de silicium est posée sur une plaque ou soumise à un gaz inerte ou au vide.

4. Procédé selon la revendication 3, caractérisé en ce qu'on utilise comme gaz inerte un gaz rare et/ou de l'hydrogène

5. Procédé selon l'une quelconque des revendications précédentes, caractérisé en ce que la croissance en épitaxie en phase gazeuse du carbure de silicium monocristallin sur le substrat de silicium est réalisée dans une première phase avec une vitesse de séparation inférieure à 20 »m/h jusqu'à ce que l'on obtienne une couche monocristalline de carbure de silicium d'une épaisseur de 5 à 50 »m, après quoi la vitesse de séparation est augmentée dans une seconde phase pour former la couche polycristalline de carbure de silicium.

6. Procédé selon la revendication 5, caractérisé en ce que la vitesse de séparation du carbure de silicium monocristallin est de 5 à 10 »m/h dans la première phase.

7. Procédé selon l'une ou l'autre des revendications 5 et 6, caractérisé en ce que la croissance du carbure de silicium polycristallin a lieu dans la seconde phase par procédé CVD plasmatique.
